# EUROPEAN PATENT SPECIFICATION

(11) **EP 1 070 297 B1**
(45) Date of publication and mention of the grant of the patent: **02.05.2003**
(21) Application number: 98952916.9
(22) Date of filing: 11.11.1998
(51) Int. Cl.: G06F 17/50

(54) **METHOD AND APPARATUS FOR AUTOMATICALLY TESTING THE DESIGN OF A SIMULATED INTEGRATED CIRCUIT**
VERFAHREN UND GERÄT ZUM AUTOMATISCHEN TEST EINES SIMULIERTEN INTEGRIERTEN SCHALTKREISES
PROCEDE ET APPAREIL D'ESSAI AUTOMATIQUE DE LA CONCEPTION D'UN CIRCUIT INTEGRE SIMULE

(30) Priority: 25.11.1997 GB 9724895
(43) Date of publication of application: 24.01.2001
(73) Proprietor: Virata Limited, Cambridge CB3 0BL (GB)
(72) Inventor: BAKER, David, Bedfordshire MK43 0NA (GB)
(74) Representative: Cozens, Paul Dennis
(86) International application number: GB9803384
(87) International publication number: WO99027472

(56) References cited:
- WO-A-94/23388
- POMERANZ I ET AL: "On the detection of reset faults;in synchronous sequential circuits" PROCEEDINGS. TENTH INTERNATIONAL CONFERENCE ON VLSI DESIGN (CAT. NO.97TB100095), PROCEEDINGS TENTH INTERNATIONAL CONFERENCE ON VLSI DESIGN, HYDERABAD, INDIA, 4-7 JAN. 1997, pages 470-474, XP002094369 ISBN 0-8186-7755-4, 1997, Los Alamitos, CA, USA, IEEE Comput. Soc. Press, USA
- HSING-CHUNG LIANG ET AL: "Identifying invalid states for sequential circuit test generation" IEEE TRANSACTIONS ON COMPUTER-AIDED DESIGN OF INTEGRATED CIRCUITS AND SYSTEMS, SEPT. 1997, IEEE, USA, vol. 16, no. 9, pages 1025-1033, XP000765262 ISSN 0278-0070

## Description

This invention relates to a method of automatically testing the design of a simulated integrated circuit containing a plurality of flip-flops. The method can be used by an ASIC designer to verify the correct operation of a circuit under initial reset conditions.

In the design of integrated circuits, sequential levels of the complexity in the design are simulated by an ASIC designer. For example, one level of design simulation may contain diagrammatic representations of flip-flops. In another different level, these flip-flops would be represented by individual gates and in a further level, by the semiconductor architecture of the integrated circuit. If any of these flip-flops would not operate correctly in the final design, this would affect the integrity of the integrated circuit. As modem ASIC designs generally contain a large amount of flip-flops which are controlled by global clock and reset networks, the timing relationship between the clock and the reset at each flip-flop is important. Otherwise the flip-flop may enter a metastable state when the reset is released, and this would cause different subsystems within the ASIC to lose synchronisation, thereby leading to system failure.

In the prior art, there are two common solutions to this problem. These globally modify the circuit and they can be applied automatically without an in-depth understanding of the circuit. However, they can add up to 5% overhead to the silicon area and are thus not cost-effective.

One prior art solution is concerned with synchronous reset flip-flops, for example, where all flip-flops are replaced with a type that synchronises the reset to the clock input. This technique has the disadvantages that the type of flip-flop required is larger and slower than the normal type; the cost of silicon is increased; and performance is reduced. The other prior art solution employs a reset tree, and this requires extra circuitry to balance the reset network. The base of this network is synchronised with the clock, so that the designer can control the timing of the reset signal and thereby avoid the problem. The disadvantage is that adding the reset tree increases the silicon area and this leads to higher cost.

The present invention seeks to avoid the extra cost of the above methods by enabling the designer to pinpoint flip-flops which suffer from a reset problem. The designer will then be able to modify the circuit to solve the problem locally.

US-A-5650946 shows how to simulate the behaviour of a circuit using an event-driven approach. It describes various approaches to simulation but does not disclose any means for correcting defective circuit behaviour. WO-A-94/23388 discloses a technique for identifying the occurrence of asynchronous behaviour in a simulation and correcting the simulation so that it operates properly. WO-A-94/02906 describes a technique for accurately modelling a device which exhibits asynchronous behaviour so that the simulation will operate correctly. Thus, the aim of all of these prior art techniques is to model a circuit so that the simulation operates correctly, i.e. with correct asynchronous operation, whereby the dynamic nature of the problem is addressed. In contrast, the invention simulates a circuit with reset flip-flops, identifies (by static analysis) which of these have potentially metastable defects, and then modifies the circuit design either by changing the reset state of the flip-flop, or by the local application of logic (such as AND-gates), so that the circuit functions correctly.

Pomeranz, et al, "On the detection of reset faults in synchronous sequential circuits", Proceedings 10th International Conference on VLSI Design (Cat. No. 97TB 100095), Proceedings 10th International Conference on VLSI Design, Hyderabad, India, 4-7 January 1997, pages 470-474, 1997, Los Alamitos, CA, USA, IEEE Comput.Soc.Press, USA relates to a method of detecting reset faults in wholly synchronous sequential circuits.

According to the invention, a method of automatically and statically testing the design of a simulated integrated circuit (ASIC) includes the steps of:
simulating a circuit having a level containing a network of flip-flops (FFₛₑₜ,FF_{cir});
putting the network into a reset state in which each flip-flop (FFₛₑₜ,FF_{cir}) would have an expected input and output state,
scanning the network and listing the input and output states;
listing the flip-flops (FFₛₑₜ,FF_{cir}) with other than the expected input and output states as having potential faults;
examining each potential fault; and
modifying the circuit design to change the reset state of the flip-flop (FFₛₑₜ,FF_{cir}), or to add logic (A) to remedy the fault, so that when the modified design is retested by putting the network into a reset state and by releasing the reset state, each flip-flop(FFₛₑₜ,FF_{cir}), will not go metastable when the reset state is released, a stable state being achieved in said flip-flop (FFₛₑₜ,FF_{cir}) when its output value does not change on a subsequent active clock transition.

The reset state of the flip-flop can be changed by amending the HDL source code for the ASIC. If logic needs to be added instead, this could add an enable signal for one or more (e.g. a group) of flip-flops. When the network of flip-flops is put into a reset state, all set D-type flip-flops will have their outputs high and all reset D-types will have their outputs low. The netlist is then scanned to check that all set type flip-flops have the D input high and all reset type flip-flops have the D input low. This will indicate whether the flip-flops would transition on the next clock if the reset was removed.

The invention makes use of the fact that a flip-flop in a stable internal state will not go metastable when reset is released. This stable state is defined as the state in which the output value will not change on the next active clock transition. For a D type flip-flop, this state occurs when the D input matches the Q output, i.e. the logic level is the same, or the voltages are those which are expected. The state of the D input is only important at the transition time of the clock. At other times it can be ignored. However when the network is held in reset all the internal signals will become stable so that the static D input can be treated as the next output. It is not necessary for the D input to be precisely equal to the Q output for a match to occur. For example, the output of a D flip-flop is constant (i.e. is remains in its previous state) until its C input is clocked. When its C input is clocked, its Q output equals its D input until the next clock pulse transition. A set D type flip-flop requires the D input to be high and conversely a reset D type requires the input to be low. Thus, the output can be forced high or low by either a set or reset input, depending on the type.

Whilst a single clock pulse edge could cause a faulty flip-flop to transition, it may be necessary to apply a series (e.g. a finite number) of clock pulses to ensure that any flip-flops with no specific reset state have settled into a static pattern.

In the preferred embodiment of the invention, a net list is analysed before reset on the network is released.

For a T type flip-flop the stable condition would be the T input inactive. For a J-K flip-flops the stable condition is J=1 K=0 when output is set and J=0 K=1 when output is clear.

Similar conditions can be defined for any particular flip-flop type.

A list of potential faults is presented to the designer, who can then address each fault by either changing the reset state, or in some circumstances adding extra logic. This extra logic will be small in cost compared to globally added circuitry which is used in the prior art methods described above. The aim of the designer is to have a single flip-flop that comes out of reset first and then enables the rest of the circuit. Such a structure will exit reset in a safe manner.

A preferred embodiment of the invention will now be described with reference to the accompanying drawing in which:
Fig. 1 represents an unstable D flip-flop network in a level of integrated circuit simulation;
Fig. 2 represents a stable D flip-flop network;and
Fig. 3 represents a D flip-flop in which the potential fault has been fixed by using logic.

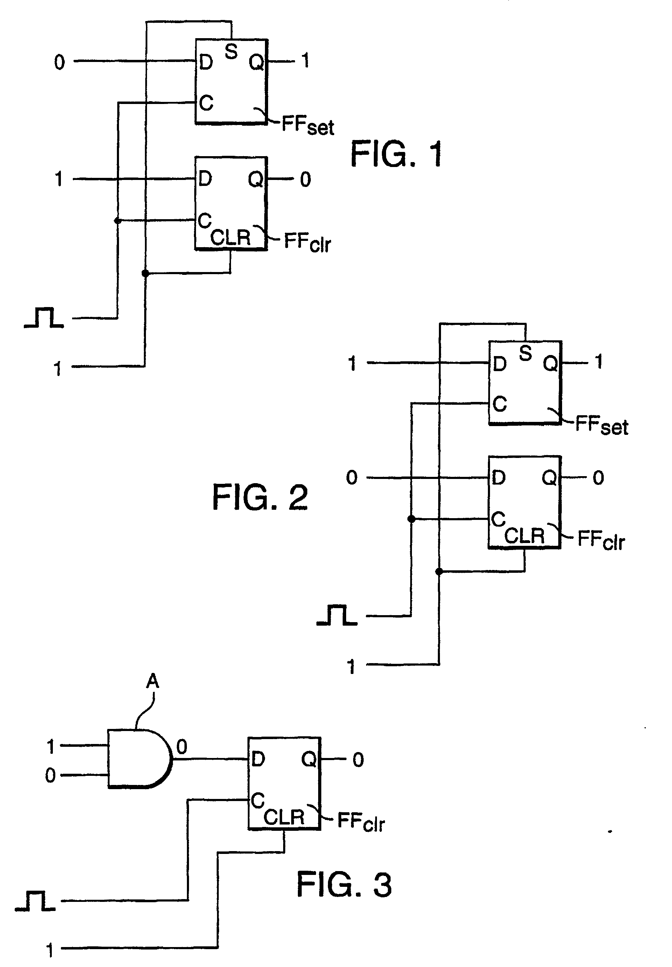

Referring to the drawings, each simulated D type flip-flop FFₛₑₜ, FF_{cir}, has a D input, a Q output and a clock C input connected to a source of clock pulses. The flip-flops FFₛₑₜ are of the set type where logic 1 on the D input produces logic 1 on the Q output. The flip-flops FF_{cir} are of the clear type where logic 1 on the D input produces logic 0 on the Q output. The network of flip-flops is put into a reset state in which each flip-flop would have an expected input and output state. The network is then scanned and the input and output states are listed. Fig.1 illustrates an unstable flip-flop network where the D input (0) does not match the Q output (1) and the flip-flop would transition on a subsequent clock pulse edge. This flip-flop network is listed or flagged as a potential fault. However, in Fig.2, the flip-flop network is stable and there is no potential fault.

It can be seen, by analogy, that the clear flip-flops in the networks of Fig. 1 and 2 are respectively unstable and stable.

In order to fix the fault, an AND-gate A can be used, as shown in Fig.3. This normally applies logic 1 and 0 to the inputs of the AND-gate, as shown, whereby the Q output is 0 when the D input is 0 (which is the output of the AND-gate). An enabling pulse (logic 1) can then be applied, at an appropriate time, so that both inputs of the AND-gate are at logic 1 to ensure that the Q output will be at logic 1.

In the preferred technique, a PLI routine is linked with a Cadence Verilog Simulator. PLI stands for "Programming Language Interface" and is an industry standard method of interfacing with the internal state of a compliant simulator. The interface involves writing a C program that calls a defined set of interface functions. The source code for the PLI functions is not included in this disclosure since the principles involved will be understood by those skilled in the art. The technique involves splitting the system up into two parts, the first logs the internal netlist state to a file and the second examines the file to produce a log report. This is done only for convenience because it is possible (in theory) to do all the processing in a single stage.

It is also possible to develop a stand alone program that could apply the entire method. The Verilog/PLI route was used for developing a working prototype.

The Cadence Verilog Simulator is known to ASIC designers. The following text is printed when it starts.

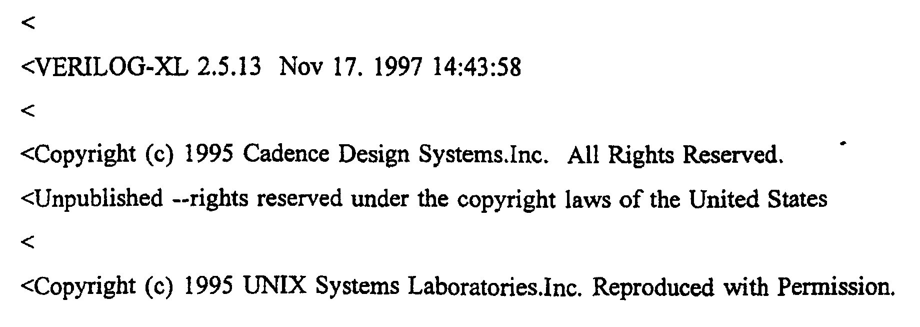

A Verilog control program is then used to force a test netlist into a reset state and then to call a PLI code that logs the state of the inputs and outputs of each flip-flop. This logged information is post-processed by an off-line program to create a list of flip-flops that have potential faults and that could enter a metastable state after reset.

## Claims

1. A method of automatically and statically testing the design of a simulated integrated circuit (ASIC) includes the steps of:
simulating a circuit having a level containing a network of flip-flops (FFₛₑₜ,FF_{cir});
putting the network in a reset state, in which each flip-flop (FFₛₑₜ,FF_{cir}) would have an expected input and output state,
scanning the network and listing the input and output states;
listing the flip-flops (FFₛₑₜ,FF_{cir}) with other than the expected input and output states as having potential faults;
examining each potential fault; and
modifying the circuit design so as to change the reset state of the flip-flop (FFₛₑₜ,FF_{cir}), or to add logic (A) to remedy the fault, so that when the modified design is retested by putting the network into a reset state and by releasing the reset state, each flip-flop (FFₛₑₜ,FF_{cir}) will not go metastable when the reset state is released, a stable state being achieved in said flip-flop (FFₛₑₜ,FF_{cir}) when its output value does not change on a subsequent active clock transition.

2. A method according to claim 1 wherein the flip-flops (FFₛₑₜ,FF_{cir}) are of the D type.

3. A method according to claim 1 wherein the flip-flops (FFₛₑₜ,FF_{cir}) are of the T type.

4. A method according to claim 1 wherein the flip-flops (FFₛₑₜ,FF_{cir}) are of the J-K type.

5. A method according to any preceding claim wherein a routine is linked with a simulator and a control program is then used to force a test netlist into a reset state; a code being called to log the state of the inputs and outputs of each flip-flop (FFₛₑₜ,FF_{cir}) and the logged information being post-processed to create a list of flip-flops (FFₛₑₜ,FF_{cir}) that have potential faults.

6. Apparatus for automatically and statically testing the design of a simulated integrated circuit, the apparatus including:
means for simulating an integrated circuit having a network of flip-flops (FFₛₑₜ,FF_{cir});
means for scanning the network and for listing the input and output states;
means for listing the flip-flops (FFₛₑₜ,FF_{cir}) which have potential faults;
means for examining each potential fault; and
means for modifying the circuit design to change the reset state of the flip-flop (FFₛₑₜ,FF_{cir}), or to add logic (A) to remedy the fault, so that when the modified design is retested by putting the network into a reset state and by releasing the reset state, each flip-flop (FFₛₑₜ,FF_{cir}), will not go metastable when the reset state is released, a stable state being achieved in said flip-flop (FFₛₑₜ,FF_{cir}), when its output value does not change on a subsequent active clock transition.

7. Apparatus according to claim 6 wherein a routine is linked with a simulator and a control program is then used to force a test netlist into a reset state, a code being called to log the state of the inputs and outputs of each flip-flop (FFₛₑₜ,FF_{cir}), and the logged information being post-processed to create a list of flip-flops (FFₛₑₜ,FF_{cir}), that have potential faults.

## Patentansprüche

1. Verfahren zum automatischen und statistischen Prüfen des Designs bzw. Aufbaus einer simulierten integrierten Schaltung (ASIC), das die Schritte enthält:
eine Schaltung wird simuliert, die ein Niveau hat, das ein Netzwerk von Flip-Flops (FFₛₑₜ,FF_{cir}) enthält;
das Netzwerk wird in einen zurückgesetzten Zustand gebracht, in welchem jedes Flip-Flop (FFₛₑₜ,FF_{cir}) einen erwarteten Eingangs- und Ausgangszustand haben würde;
das Netzwerk wird abgetastet bzw. abgescannt und die Eingangs- und Ausgangszustände werden aufgelistet;
die Flip-Flops (FFₛₑₜ,FF_{cir}) mit anderen als den erwarteten Eingangs- und Ausgangszuständen werden als potentielle Fehler aufweisend aufgelistet bzw. erfasst; jeder potentielle Fehler wird geprüft; und
das Schaltungsdesign bzw. der Schaltungsaufbau wird modifiziert bzw. verändert, um so den Rücksetzzustand des Flip-Flops (FFₛₑₜ,FF_{cir}) zu ändern, oder um Logik (A) hinzuzufügen, um den Fehler zu beheben, so dass, wenn das modifizierte bzw. veränderte Design wieder getestet wird, indem das Netzwerk in einen zurückgesetzten Zustand versetzt wird und indem der Zurücksetzungszustand ausgelöst wird, jedes Flip-Flop (FFₛₑₜ,FF_{cir}) nicht metastabil werden wird, wenn der Zurücksetzungszustand ausgelöst ist, wobei ein stabiler Zustand indem Flip-Flop (FFₛₑₜ,FF_{cir}) erzielt wird, wenn sein Ausgangswert bei einem nachfolgenden aktiven Taktübergang nicht geändert wird.

2. Verfahren nach Anspruch 1, wobei die Flip-Flops (FFₛₑₜ,FF_{cir}) von dem D-Typ sind.

3. Verfahren nach Anspruch 1, wobei die Flip-Flops (FFₛₑₜ,FF_{cir}) von dem T-Typ sind.

4. Verfahren nach Anspruch 1, wobei die Flip-Flops (FFₛₑₜ,FF_{cir}) von dem J-K-Typ sind.

5. Verfahren nach einem der voranstehenden Ansprüche, wobei eine Routine bzw. ein Unterprogramm mit einem Simulator verbunden bzw. verknüpft wird, und ein Steuerprogramm dann verwendet wird, um eine Test- bzw. Prüfnetztafel in einen zurückgesetzten Zustand zu drängen; wobei ein Code aufgerufen wird, um den Zustand der Eingänge und Ausgänge von jedem Flip-Flop (FFₛₑₜ,FF_{cir}) zu protokollieren und die protokollierten Informationen werden nachverarbeitet, um eine Liste von Flip-Flops (FFₛₑₜ,FF_{cir}) zu erzeugen, die potentielle Fehlfunktionen bzw. Fehler haben.

6. Vorrichtung zum automatischen und statistischen Testen bzw. Prüfen des Designs bzw. des Schaltungsaufbaus einer simulierten integrierten Schaltung, wobei die Vorrichtung enthält:
Mittel zum Simulieren einer integrierten Schaltung, die ein Netzwerk von Flip-Flops (FFₛₑₜ,FF_{cir}) hat;
Mittel zum Abtasten bzw, Scannen des Netzwerkes und zum Auflisten der Eingangsund Ausgangszustände;
Mittel zum Auflisten der Flip-Flops (FFₛₑₜ,FF_{cir}), die potentielle Fehlfunktionen bzw. Fehler haben;
Mittel zum Prüfen jedes potentiellen Fehlers bzw. Fehlfunktion; und
Mittel zum modifizieren des Schaltungsdesigns, um den zurückgesetzten Zustand des Flip-Flops (FFₛₑₜ,FF_{cir}) zu ändern, oder um eine Logik (A) hinzuzufügen, um den Fehler bzw. die Fehlfunktion zu beseitigen, so dass, wenn das modifizierte Design bzw. der modifizierte Schaltplan wieder getestet wird, indem das Netzwerk in einen zurückgesetzten Zustand versetzt wird, und indem der zurückgesetzte Zustand ausgegeben wird, jedes Flip-Flop (FFₛₑₜ,FF_{cir}) nicht metastabil wird, wenn der zurückgesetzte Zustand ausgegeben wird, wobei ein stabiler Zustand in jedem Flip-Flop (FFₛₑₜ,FF_{cir}) erzielt wird, wenn sein Ausgangswert bei einem nachfolgenden aktiven Taktübergang nicht geändert wird.

7. Vorrichtung nach Anspruch 6, wobei eine Routine bzw. ein Unterprogramm mit einem Simulator verbunden wird und dann ein Steuerprogramm verwendet wird, um eine Prüfnetztafel in einen zurückgesetzten Zustand zu drangen, wobei ein Code aufgerufen wird, um den Zustand der Eingänge und Ausgänge von jedem Flip-Flop (FFₛₑₜ,FF_{cir}) zu protokollieren, und die protokollierten Informationen werden nachverarbeitet, um eine Liste von Flip-Flops (FFₛₑₜ,FF_{cir}) zu erzeugen, die potentielle Fehler bzw. Fehlfunktionen haben.

## Revendications

1. Un procédé pour tester automatiquement et de manière statique la conception d'un circuit intégré (ASIC) simulé, comprenant les étapes suivantes :
on simule un circuit ayant un niveau contenant un réseau de bascules (FFₛₑₜ, FF_{cir});
on place le réseau dans un état restauré, dans lequel chaque bascule (FFₛₑₜ, FF_{cir}) aurait un état d'entrée et de sortie prévu;
on scrute le réseau et on dresse la liste des états d'entrée et de sortie;
on dresse la liste des bascules (FFₛₑₜ, FF_{cir}) avec des états d'entrée et de sortie autres que ceux prévus, en tant que bascules ayant des défauts potentiels;
on examine chaque défaut potentiel; et
on modifie la conception du circuit de façon à changer l'état restauré de la bascule (FFₛₑₜ, FF_{cir}), ou à ajouter un élément logique (A) pour remédier au défaut, de façon que lorsque la conception modifiée est testée à nouveau en plaçant le réseau dans un état restauré et en libérant l'état restauré, chaque bascule (FFₛₑₜ, FF_{cir}) ne devienne pas métastable lorsque l'état restauré est libéré, un état stable étant obtenu dans la bascule (FFₛₑₜ, FF_{cir}) lorsque sa valeur de sortie ne change pas au moment d'une transition d'horloge active suivante.

2. Un procédé selon la revendication 1, dans lequel les bascules (FFₛₑₜ, FF_{cir}) sont du type D.

3. Un procédé selon la revendication 1, dans lequel les bascules (FFₛₑₜ, FF_{cir}) sont du type T.

4. Un procédé selon la revendication 1, dans lequel les bascules (FFₛₑₜ, FF_{cir}) sont du type J-K.

5. Un procédé selon l'une quelconque des revendications précédentes, dans lequel une routine est liée au simulateur et un programme de commande est ensuite utilisé pour forcer une liste de réseau de test dans un état restauré; un code étant appelé pour consigner l'état des entrées et des sorties de chaque bascule (FFₛₑₜ, FF_{cir}), et l'information consignée étant post-traitée pour créer une liste de bascules (FFₛₑₜ, FF_{cir}) qui ont des défauts potentiels.

6. Dispositif pour tester automatiquement et de façon statique la conception d'un circuit intégré simulé, le dispositif incluant :
des moyens pour simuler un circuit intégré ayant un réseau de bascules (FFₛₑₜ, FF_{cir});
des moyens pour scruter le réseau et pour dresser la liste des états d'entrée et de sortie;
des moyens pour dresser la liste des bascules (FFₛₑₜ, FF_{cir}) qui ont des défauts potentiels;
des moyens pour examiner chaque défaut potentiel; et
des moyens pour modifier la conception de circuit pour changer l'état restauré de la bascule (FFₛₑₜ, FF_{cir}), ou pour ajouter un élément logique (A) pour remédier au défaut, de façon que lorsque la conception modifiée est testée à nouveau en plaçant le réseau dans un état restauré et en libérant l'état restauré, chaque bascule (FFₛₑₜ, FF_{cir}) ne devienne pas métastable lorsque l'état restauré est libéré, un état stable étant atteint dans la bascule (FFₛₑₜ, FF_{cir}) lorsque sa valeur de sortie ne change pas au moment d'une transition d'horloge active suivante.

7. Dispositif selon la revendication 6, dans lequel une routine est liée à un simulateur et un programme de commande est ensuite utilisé pour forcer une liste de réseau de test dans un état restauré, un code étant appelé pour consigner l'état des entrées et des sorties de chaque bascule (FFₛₑₜ, FF_{cir}), et l'information consignée étant post-traitée pour créer une liste de bascules (FFₛₑₜ, FF_{cir}) qui ont des défauts potentiels.
